# EUROPEAN PATENT SPECIFICATION

(11) **EP 2 045 356 B1**
(45) Date of publication and mention of the grant of the patent: **05.08.2015**
(21) Application number: 08016876.8
(22) Date of filing: 25.09.2008
(51) Int. Cl.: C23C 16/34, C23C 16/507

(54) **Method of forming silicon nitride films**
Verfahren zur Herstellung von Siliciumnitridfilm
Procédé de formation de films de nitrure de silicium

(30) Priority: 27.09.2007 JP 2007251506
(43) Date of publication of application: 08.04.2009
(73) Proprietor: FUJIFILM Corporation, Minato-ku Tokyo (JP)
(72) Inventor: Takahashi, Toshiya, Odawara-shi Kanagawa (JP)
(74) Representative: Hoffmann Eitle

(56) References cited:
- DE-A1- 19 943 741
- US-B1- 6 380 612

## Description

The entire contents of a document cited in this specification are incorporated herein by reference.

### BACKGROUND OF THE INVENTION

The present invention relates to the technical field of forming silicon nitride films by plasma-enhanced chemical vapor deposition (CVD). The invention more specifically relates to a silicon nitride film-forming method capable of forming high-density films with excellent water vapor barrier properties through inductively coupled plasma-enhanced chemical vapor deposition.

Silicon nitride films are employed as water vapor barrier films in various devices and optical elements requiring moisture resistance, and protective films (passivation films) and insulating films in semiconductor devices.

Plasma-enhanced CVD is used in methods of forming silicon nitride films.

A known technique of film formation by plasma-enhanced CVD is capacitively coupled plasma-enhanced chemical vapor deposition (hereinafter abbreviated as "CCP-CVD"), which is a technique involving applying a radio frequency voltage to two opposing electrodes to generate plasma between the electrodes, thus forming a film.

CCP-CVD has the following advantages: The structure is simple; and a gas material is supplied from the electrodes, which enables gas to be uniformly supplied to the whole film-forming area even in the case where the electrodes have an increased surface area (the gas is easily made uniform).

On the other hand, CCP-CVD suffers from a plasma electron density of as low as about 1 × 10⁸ to about 1 × 10¹⁰ electrons/cm³ and has difficulties in improving the film deposition rate. In addition, because the electrodes are present in the plasma-generating region, film deposition continued for an extended period of time causes adhesion and deposition of a film to the electrodes as well, which may hinder proper film deposition.

Under the circumstances, in equipment where film deposition is carried out as an elongated polymer film or other material is transported in a longitudinal direction with a view to, for example, producing water vapor barrier films in large quantities, the polymer film serving as a substrate cannot travel at an improved speed, which may often not ensure high productivity. Film deposition to the electrodes also limits the length of the polymer film serving as a substrate.

What is more, CCP-CVD requires a high pressure of usually about several tens of Pa to about several hundred Pa to maintain plasma, and in cases where film deposition is continuously carried out in a plurality of film deposition spaces (film deposition chambers) connected to each other, has a deteriorated film quality due to undesired incorporation of a gas in any of the film deposition chambers.

In addition to the above-described CCP-CVD, plasma-enhanced CVD also includes a known technique called inductively coupled plasma-enhanced chemical vapor deposition (hereinafter abbreviated as "ICP-CVD").

ICP-CVD is a technique which involves supplying radio frequency power to an (induction) coil to form an induced magnetic field and an induced electric field, and generating plasma based on the induced electric field to form a film on a substrate.

ICP-CVD is a technique in which radio frequency power is supplied to a coil to form an induced electric field to thereby generate plasma and therefore requires no counter electrode which is essential in plasma formation by means of CCP-CVD. Plasma having a density of as high as at least 1 × 10¹¹ electrons/cm³ can also be easily generated. In addition, plasma can be generated at a lower pressure and a lower temperature compared with plasma formation by means of CCP-CVD.

Upon manufacture of semiconductor devices, silicon nitride films are formed by ICP-CVD.

For example, JP 2005-79254 A describes that a silicon nitride film has been conventionally formed through ICP-CVD by using a gas material including silane gas and ammonia gas and adjusting the substrate temperature and the radio frequency power to 350QC or higher and 6W/sccm or more, respectively.

JP 2005-79254 A also describes a silicon nitride film-forming method which aimed at preventing a decline in film quality due to an increased hydrogen content in the film as having been seen in the above-mentioned conventional silicon nitride film-forming method and according to which a silicon nitride film is formed through ICP-CVD at a substrate temperature of 50 to 300°C by supplying a gas material including silane gas and nitrogen gas in such a manner that the flow rate (supply flow rate) of the nitrogen gas is at least ten times that of the silane gas and by applying a radio frequency power of at least 3 W/sccm with respect to the total gas flow rate.

It is also described that, in this silicon nitride film-forming method, an inert gas serving as an excitation gas is supplied at a flow rate corresponding to up to 20% of the total flow rate of the silane gas and the nitrogen gas to improve the film deposition rate. DE19943741A1 disclose a silicon nitride film forming method wherein siliane gas, ammonia gas and an inert gas are supplied in such a manner that a flow rate of the inert gas is about 6.8 or 13.7 times a total flow rate of the silane gas and the ammonia gas.

### SUMMARY OF THE INVENTION

The above-mentioned method of forming (depositing) a silicon nitride film is capable of film deposition at a relatively low temperature while reducing the hydrogen content in the film.

However, because the nitrogen gas used as the gas material has a low activity, this silicon nitride film-forming method is low in film deposition rate and, as described above, is not capable of efficient film production in equipment where film deposition is continuously carried out on an elongated polymer film or other substrate.

A high-quality silicon nitride film is required to have a high density and is of course required to have high water vapor barrier properties (a low water vapor transmission rate) as well when the silicon nitride film is applied to a water vapor barrier film.

In the case of forming a silicon nitride film on an organic substance layer or the case of using the above-mentioned polymer film for the substrate, film deposition needs to be carried out at a substrate temperature of 200°C or lower. In other words, the silicon nitride film-forming method as disclosed in JP 2005-79254 A in which the substrate temperature is set to 350°C or higher cannot be employed in these cases.

Film deposition at such a low temperature reduces the film density. Therefore, such conventional silicon nitride film-forming method cannot provide high-density silicon nitride films.

The present invention has been made to solve the aforementioned conventional problems and it is an object of the present invention to provide a silicon nitride film-forming method which is capable of forming, at a low film deposition temperature and a high film deposition rate, a silicon nitride film which is high in density and hardness, is excellent in resistance to scratching, and can exhibit good water vapor barrier properties when applied to a water vapor barrier film.

In order to achieve the above object, the present invention provides a silicon nitride film-forming method comprising the steps of: supplying a gas material including silane gas, ammonia gas and an inert gas in such a manner that a flow rate of the inert gas is 1 to 5 times a total flow rate of the silane gas and the ammonia gas; and carrying out inductively coupled plasma-enhanced chemical vapor deposition to form a silicon nitride film.

The inert gas is preferably helium gas. The silicon nitride film is formed at a substrate temperature of from 0°C to 150°C. The silicon nitride film is preferably formed on an organic material. The silicon nitride film is preferably formed on a substrate having a base material made of a polymer film.

According to the present invention having the features described above, film deposition is carried out by ICP-CVD as the gas material including silane gas, ammonia gas and an inert gas such as helium is supplied in such a manner that the flow rate of the inert gas is 1 to 5 times the total flow rate of the silane gas and the ammonia gas, whereby can be consistently formed even at a low film deposition temperature a high-quality silicon nitride film having excellent characteristics including high density, sufficiently high hardness to resist scratching, and excellent water vapor barrier properties achieved when it is applied to a water vapor barrier film (moisture barrier film).

The forming method of the invention uses highly reactive ammonia gas as the gas material and therefore ensures high film deposition rate as well.

### BRIEF DESCRIPTION OF THE DRAWINGS

FIG. 1 is a graph showing the relation between the density of the silicon nitride films and the helium flow rate in Examples of the invention and Comparative Example; and
FIG. 2 is a graph showing the relation between the water vapor transmission rate of the substrates each having a silicon nitride film formed thereon and the helium flow rate in Examples of the invention and Comparative Example.

### DETAILED DESCRIPTION OF THE PREFERRED EMBODIMENTS

On the pages that follow, the silicon nitride film-forming method of the present invention is described in detail with reference to the accompanying drawings.

According to the silicon nitride film-forming method of the invention, a silicon nitride film is formed (deposited) through ICP-CVD by using a gas material including not only silane gas and ammonia gas but also an inert gas in such a manner that the flow rate (supply flow rate) of the inert gas is 1 to 5 times the total flow rate (total quantity of flow) of the silane gas and the ammonia gas.

The inventor has made intensive studies on the formation of a silicon nitride film at a low temperature and in particular at a substrate temperature of as low as about 0°C to 150°C at which film deposition on a polymer film is possible, with a view to seeking a method with which a film having a high density and excellent water vapor barrier properties (low moisture permeability) can be formed.

As a result, it has been found that a silicon nitride film which has a high enough density and excellent water vapor barrier properties and is sufficiently high in hardness to resist scratching can be formed even at the low film deposition temperature as described above by introducing, in addition to silane gas and ammonia gas directly contributing to the film formation, an inert gas such as helium gas in an amount 1 to 5 times the total flow rate (total quantity of flow) of the silane gas and the ammonia gas, and the present invention has been completed.

Usually, an inert gas is very often added in forming a film through ICP-CVD to stabilize discharge (maintain a high plasma density) and improve film thickness distribution.

On the other hand, in the present invention, by applying ICP-CVD in the silicon nitride film formation and further introducing a predetermined quantity of inert gas as well as the silane gas and the ammonia gas serving to form a film, a high-quality silicon nitride film which has improved film density and water vapor barrier properties and is high in hardness and resistant to scratching is formed even at a low film deposition temperature. What is more, use of highly active ammonia gas as the gas material ensures a high enough film deposition rate, and a high film travel speed and high productivity can be ensured even in the case of, for example, continuously forming a silicon nitride film as an elongated polymer film travels in a longitudinal direction.

As described above, in the silicon nitride film-forming method of the invention, the inert gas is used at the flow rate 1 to 5 times the total flow rate of the silane gas (SiH₄) and the ammonia gas (NH₃).

At an inert gas flow rate of less than the total flow rate of the silane gas and the ammonia gas, improvement of the density and the water vapor barrier properties cannot be fully achieved, and particularly in the case where film deposition is performed at a low temperature on a substrate made of, for example, a polymer film, a high-density silicon nitride film having high water vapor barrier properties cannot be obtained.

On the other hand, the study made by the inventor of the invention indicates that the higher the flow rate of the inert gas is, the more the density and the water vapor barrier properties are basically improved. However, at an inert gas flow rate of more than ten times the total flow rate of the silane gas and the ammonia gas, the pressure is excessively increased to impair the uniformity in film thickness distribution. If the pressure is kept constant, the ratio of silane gas and ammonia gas which are not involved in the reaction and are therefore discharged is increased to lower the film deposition rate. In this way, film deposition conditions suitable to form a silicon nitride film cannot be ensured. In other words, there are cases where a film cannot be formed properly in a consistent manner.

The flow rate of the inert gas is preferably 2 to 5 times the total flow rate of the silane gas and the ammonia gas.

By setting the flow rate of the inert gas to more than twice the total flow rate of the silane gas and the ammonia gas, a high-density silicon nitride film having high water vapor barrier properties can be consistently formed even at a substrate temperature of as low as up to 150°C. In addition, by setting the flow rate of the inert gas to up to 5 times the total flow rate of the silane gas and the ammonia gas, film deposition conditions suitable to form a silicon nitride film can be consistently ensured, in other words, a high-quality silicon nitride film can be formed in a consistent manner.

So-called rare gases such as helium gas, neon gas, argon gas, krypton gas, xenon gas, and radon gas are all available as inert gases, and in terms of, for example, ionization energy, atomic radius, atomic mass and cost, helium gas, neon gas, argon gas and krypton gas are preferably used, with helium gas being more preferred.

In the present invention, the number of inert gases used is not limited to one, but a plurality of inert gases may be used.

In the practice of the invention, as long as the condition that the flow rate of the inert gas is 1 to 5 times the total flow rate of the silane gas and the ammonia gas is met, the gas material may optionally further include gases other than these gases.

In the method of the invention to form a silicon nitride film, the total flow rate of the silane gas and the ammonia gas is not particularly limited but may be appropriately determined according to the required film deposition rate and film thickness.

According to the study made by the inventor of the invention, the total flow rate of the silane gas and the ammonia gas is preferably from 1 to 10,000 sccm and more preferably from 100 to 5,000 sccm.

By adjusting the total flow rate of the silane gas and the ammonia gas within the above-defined range, preferable results are obtained in terms of, for example, productivity and discharge stability.

The ratio of the flow rate of the silane gas to that of the ammonia gas is also not limited to any particular value, but may be appropriately set according to the composition (compositional ratio) of the silicon nitride film to be formed.

According to the study made by the inventor of the invention, the silane gas and the ammonia gas are preferably used at a flow rate ratio of the silane gas to the ammonia gas of from 1:1 to 1:10.

By adjusting the flow rate ratio between the silane gas and ammonia gas within the above-defined range, the effect of the invention that a high-density silicon nitride film having excellent characteristics such as good water vapor barrier properties is obtained even at a low film deposition temperature can be more advantageously achieved. What is more, preferable results are also obtained from the viewpoint that a silicon nitride film with a good composition can be formed.

In the method of the invention to form a silicon nitride film, the radio frequency power to be supplied for film deposition (hereinafter abbreviated as "RF power" which refers to electromagnetic wave energy applied to the film deposition system (film deposition chamber) is also not limited to any particular value but may be appropriately determined according to the required film deposition rate and film thickness.

According to the study made by the inventor of the invention, the RF power supplied for film deposition is preferably from 0.5 to 30 W/sccm and more preferably from 1 to 10 W/sccm with respect to the total flow rate of the gas material for use in film deposition.

By adjusting the RF power within the above-defined range, preferable results are obtained in terms of, for example, discharge stability and reduced damage to the substrate.

In the method of forming a silicon nitride film according to the invention, the film deposition pressure is also not limited to any particular value but may be appropriately determined according to the required film deposition rate and film thickness as well as the flow rate of the gas material.

According to the study made by the inventor of the invention, the film deposition pressure is preferably in a range of from 0.5 to 20 Pa.

By adjusting the film deposition pressure within the above-defined range, the effect of the invention that a high-density silicon nitride film having excellent characteristics such as good water vapor barrier properties is obtained even at a low film deposition temperature can be more advantageously achieved-What is more, preferable results are also obtained in terms of, for example, discharge stability and reduced damage to the substrate.

Furthermore, in the method of forming a silicon nitride film according to the present invention, the film deposition rate is also not limited to any particular value but may be determined as appropriate for the required productivity or other factors.

A silicon nitride film is formed by the silicon nitride film-forming method of the invention at a substrate temperature of 0°C to 150°C.

As is well known, in film formation through CVD, a film can be formed at a high enough density regardless of the gas material used, flow rate, and method of plasma generation if the substrate can be used (film deposition can be carried out) at a high temperature. However, film deposition at a high temperature is often impossible depending on the substrate material and the layer previously formed.

In contrast, the present invention can form a silicon nitride film that has a high enough density and exhibits high water vapor barrier properties even at a low temperature of not more than 150°C. By adjusting the substrate temperature in a range of from 0°C to 150°C, a high-density silicon nitride film that has excellent water vapor barrier properties can also be formed on less heat-resistant substrates such as one made of a polymer film and one having an organic layer formed thereon.

In other words, by adjusting the substrate temperature in a range of from 0°C to 150°C, the effect of the invention is achieved, and more specifically, polymer film-based, water vapor barrier films (moisture barrier films) that have high water vapor barrier properties and have been unattainable in the conventional silicon nitride film-forming methods can be prepared with high productivity.

According to the silicon nitride film-forming method of the present invention, there is no particular limitation on the substrate (film deposition substrate) on which a silicon nitride film is to be formed, and any substrate on which a silicon nitride film can be formed is available.

Since the effect of the invention that a high-density silicon nitride film having excellent water vapor barrier properties can be formed even at a low film deposition temperature can be advantageously achieved, a silicon nitride film is preferably formed on a less heat-resistant substrate having an organic layer (organic substance layer) such as a polymer layer (resin layer) formed thereon, more preferably on a substrate having an organic layer on which the film is to be deposited, and even more preferably on a substrate made of a polymer film (resin film).

A silicon nitride film may be formed (film deposition may be carried out) by implementing the silicon nitride film-forming method of the invention basically in the same manner as in a conventional ICP-CVD process except that the gas material including silane gas, ammonia gas and an inert gas is used and the flow rate of the inert gas is adjusted in the above-defined predetermined range.

Therefore, the present invention avoids the necessity of using a special film deposition device and may be carried out by using a common ICP-CVD film deposition device in which RF power is supplied to an (induction) coil to form an induced magnetic field and therefore an induced electric field, and the gas material is introduced in the area of the induced electric field to generate plasma, thus forming a film on the substrate. Any known CVD devices (film deposition devices) to which an ICP-CVD process is applied are all available. However, as described above, film deposition is carried out at a substrate temperature of 0°C to 150°C and therefore a film deposition device having a function of substrate cooling is used.

### EXAMPLES

The present invention is described below in further detail with reference to specific examples of the invention.

### Example 1

A common CVD device based on an ICP-CVD process was used to form a silicon nitride film on a substrate.

The substrate used was a polyester film with a thickness of 188 µm (polyethylene terephthalate film "Luminice" manufactured by Toray Advanced Film Co., Ltd.).

The substrate was set at a predetermined position within a vacuum chamber, and the vacuum chamber was closed.

Then, the vacuum chamber was evacuated to reduce the internal pressure. When the internal pressure had reached 7 × 10⁻⁴ Pa, silane gas, ammonia gas and helium gas were introduced into the vacuum chamber at flow rates of 50 sccm, 150 sccm and 300 sccm, respectively. In other words, the flow rate of the helium gas was 1.5 times the total flow rate of the silane gas and the ammonia gas.

Evacuation of the vacuum chamber was adjusted so that the vacuum chamber had an internal pressure of 5 Pa.

Then, 2 kW RF power was supplied to an induction coil and formation of a silicon nitride film on the surface of the substrate was started by ICP-CVD. During the film formation, the substrate temperature was controlled with a temperature adjusting means disposed at a substrate holder so that the substrate had a temperature of 70°C.

Formation of the silicon nitride film was finished when the film thickness had reached 100 nm based on the film deposition rate previously studied by experiments, and the substrate having the film deposited thereto was taken out of the vacuum chamber.

The density of the resulting silicon nitride film was measured by an X-ray reflectivity technique.

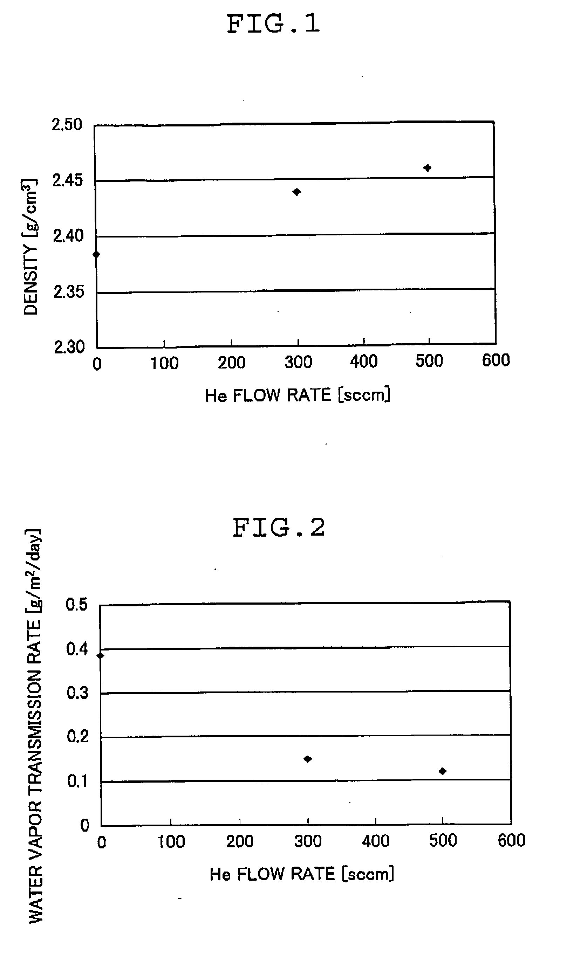

The water vapor transmission rate of the substrate having the silicon nitride film formed thereon was measured by the MOCON method. The measurement results of the density and the water vapor transmission rate are shown in FIGS. 1 and 2, respectively.

### Example 2

Example 1 was repeated except that the helium gas was introduced into the vacuum chamber at a flow rate of 500 sccm, that is, at a flow rate 2.5 times the total flow rate of the silane gas and the ammonia gas, thereby forming a silicon nitride film on the surface of the substrate of the same type as in Example 1.

### Comparative Example 1

Example 1 was repeated except that no helium gas was introduced into the vacuum chamber, thereby forming a silicon nitride film on the surface of the substrate of the same type as in Example 1.

For the silicon nitride films obtained in Example 2 and Comparative Example 1 and the substrates having the silicon nitride films formed thereon, the density and the water vapor transmission rate were measured in exactly the same manner as in Example 1. The results are shown in FIGS. 1 and 2.

As is seen from FIGS. 1 and 2, excellent results are obtained on both of the density and the water vapor barrier properties in Examples 1 and 2 of the invention in which the silicon nitride films were formed through ICP-CVD by using the gas material including the silane gas, ammonia gas and helium gas, with the helium gas being introduced at a flow rate 1 to 10 times the total flow rate of the silane gas and the ammonia gas, as compared with Comparative Example 1 in which no inert gas was introduced according to a conventional film deposition method.

The composition of the silicon nitride film in Example 2 was examined by electron spectroscopy for chemical analysis. As a result, the resulting silicon nitride film contained 48% of silicon, 48% of nitrogen, 1% of oxygen and 3% of impurities, and therefore had a good composition and contained very small amounts of impurities.

The above results clearly show the beneficial effects of the present invention.

## Claims

1. A silicon nitride film-forming method comprising the steps of:
supplying a gas material including silane gas, ammonia gas and an inert gas in such a manner that a flow rate of the inert gas is 1 to 5 times a total flow rate of the silane gas and the ammonia gas; and
carrying out inductively coupled plasma-enhanced chemical vapor deposition to form a silicon nitride film,
wherein said silicon nitride film is formed at a substrate temperature of from 0°C to 150°C.

2. The silicon nitride film-forming method according to claim 1, wherein said inert gas is helium gas.

3. The silicon nitride film-forming method according to claim 1 or 2, wherein said silicon nitride film is formed on an organic material.

4. The silicon nitride film-forming method according to any one of claims 1 to 3, wherein said silicon nitride film is formed on a substrate having a base material made of a polymer film.

## Patentansprüche

1. Siliciumnitridfilmbildendes Verfahren, umfassend die Schritte:
Zuführen eines Gasmaterials, einschliesslich eines Silangases, Ammoniakgases und Inertgases, in einer solchen Weise, dass die Fliessgeschwindigkeit des Inertgases das 1- bis 5-fache der Gesamtfliessgeschwindigkeit des Silangases und des Ammoniakgases beträgt; und
Durchführen einer durch ein induktiv gekoppeltes, Plasma unterstützten, chemischen Dampfabscheidung, um einen Siliciumnitridfilm zu bilden,
wobei der Siliciumnitridfilm bei einer Substrattemperatur von 0 bis 150°C gebildet wird.

2. Siliciumnitridfilmbildendes Verfahren gemäss Anspruch 1, wobei das Inertgas Heliumgas ist.

3. Siliciumnitridfilmbildendes Verfahren gemäss Anspruch 1 oder 2, wobei der Siliciumnitridfilm auf einem organischen Material gebildet wird.

4. Siliciumnitridfilmbildendes Verfahren gemäss einem der Ansprüche 1 bis 3, wobei der Siliciumnitridfilm auf einem Substrat gebildet wird, das ein Basismaterial aus einem Polymerfilm aufweist.

## Revendications

1. Procédé de formation de film de nitrure de silicium comprenant les étapes qui consistent :
à fournir un matériau gazeux comportant du gaz silane, du gaz ammoniac et un gaz inerte de manière à ce qu'un débit du gaz inerte soit de 1 à 5 fois un débit total du gaz silane et du gaz ammoniac ; et
à effectuer un dépôt chimique en phase vapeur activé par plasma à couplage inductif pour former un film de nitrure de silicium,
dans lequel ledit film de nitrure de silicium est formé à une température de substrat allant de 0°C à 150°C.

2. Procédé de formation de film de nitrure de silicium selon la revendication 1, dans lequel ledit gaz inerte est du gaz hélium.

3. Procédé de formation de film de nitrure de silicium selon la revendication 1 ou 2, dans lequel ledit film de nitrure de silicium est formé sur un matériau organique.

4. Procédé de formation de film de nitrure de silicium selon l'une quelconque des revendications 1 à 3, dans lequel ledit film de nitrure de silicium est formé sur un substrat ayant un matériau de base réalisé en un film de polymère.
